# EUROPÄISCHE PATENTSCHRIFT

(11) **EP 0 853 832 B1**
(45) Veröffentlichungstag und Bekanntmachung des Hinweises auf die Patenterteilung: **09.06.1999**
(21) Anmeldenummer: 96934501.6
(22) Anmeldetag: 30.09.1996
(51) Int. Cl.: H02B 1/30, H02B 1/01

(54) **RAHMENGESTELL FÜR EINEN SCHALTSCHRANK**
FRAMEWORK FOR SWITCHGEAR CABINETS
CADRE POUR ARMOIRE DE DISTRIBUTION

(30) Priorität: 04.10.1995 DE 19536950
(43) Veröffentlichungstag der Anmeldung: 22.07.1998
(73) Patentinhaber: Rittal-Werk Rudolf Loh GmbH & Co. KG, 35745 Herborn (DE)
(72) Erfinder: BENNER, Rolf, D-35745 Herborn-Amdorf (DE); REUTER, Wolfgang, D-57299 Burbach (DE)
(74) Vertreter: Fleck, Hermann-Josef, Dr.-Ing.
(86) Internationale Anmeldenummer: EP9604276
(87) Internationale Veröffentlichungsnummer: WO9713304

(56) Entgegenhaltungen:
- DE-A- 4 132 803
- DE-A- 4 336 187
- DE-A- 4 336 204
- DE-U- 8 107 658
- DE-U- 8 703 695

## Beschreibung

Die Erfindung betrifft ein Rahmengestell aus Rahmenschenkeln für einen Schaltschrank, bei dem die Rahmenschenkel vorzugsweise spiegelbildlich zu ihrer Querschnittsdiagonalen ausgebildet sind und senkrecht zu den Außenseiten des Rahmengestelles stehende und mit Befestigungsaufnahmen versehene Profilseiten aufweisen, die im Bereich der Innenseite in Abschnitte übergehen, die eine Aufnahme zur Befestigung von Montageschienen bilden.

Ein Rahmengestell dieser Art ist durch die DE 43 36 204 A1 bekannt, wobei die Aufnahme durch Abschnitte des Rahmenschenkels begrenzt ist, die senkrecht zu den Profilseiten des Rahmenschenkels stehen und eine Aufnahme für im Querschnitt im wesentlichen quadratische Montageschienen bilden.

Rahmenschenkel für Rahmengestelle eines Schaltschrankes sind in den unterschiedlichsten Querschnittsformen bekannt, wie auch die DE 40 36 664 A1, die DE 41 32 803 A1, die DE 81 07 658 U1 und die DE 87 03 695 U1 zeigen.

Die Rahmenschenkel nach der DE 40 36 664 A1 und der DE 81 07 658 U1 weisen in den Außenseiten des Rahmengestelles bildenden Abschnitten Aufnahmenuten für Dichtungselemente auf.

Aus der DE 41 32 803 A1 und der DE 87 03 695 U1 ist es bekannt, an die die Außenseiten des Rahmengestelles bildenden Abschnitte im 135°-Winkel Verbindungsabschnitte anzuschließen, die über senkrecht zu den Profilseiten stehende Profilabschnitte mit den Profilseiten verbunden sind.

Aus der DE 81 07 658 U1 und der DE 87 03 695 U1 gehen jeweils verschiedene parallele und senkrecht zu den die Außenseiten bildenden Profilseiten stehende Profilabschnitte hervor, die zur Innenseite des Rahmengestelles gerichtet und mit Befestigungsaufnahmen versehen sind.

Alle diese aus Rahmenschenkeln zusammengesetzten Rahmengestelle erfüllen mehr oder weniger gut die an einen Schaltschrank gestellten Anforderungen. So wird im einen Fall die dichte Anbringung der Verkleidungselemente am Rahmengestell verbessert, während im anderen Fall die Befestigungsmöglichkeiten auf der Innenseite des Rahmengestelles verwertet und erleichtert wird. Die Abschrägung der Außenkanten bringt eine Aufnahme für die Abkantungen der Verkleidungselemente und Platz für Scharnier- und Schließelemente.

Es ist Aufgabe der Erfindung, ein Rahmengestell der eingangs erwähnten Art zu schaffen, das mit einfach herstellbaren Rahmenschenkeln die an einen Schaltschrank gestellten Anforderungen bezüglich der dichten Anbringung von abgekanteten Verkleidungselementen, der Schaffung einer ausreichend großen Außenkanten-Aufnahme für die Abkantungen der Verkleidungselemente und für die Anbringung von Scharnier- und Schließelementen und der universellen Befestigungsmöglichkeiten im Bereich der Innenseite des Rahmengestelles auf optimale Weise löst.

Diese Aufgabe wird nach der Erfindung durch die Kombination der nachstehenden Merkmale gelöst:
a) die Profilseiten der Rahmenschenkel sind über einen Verbindungsabschnitt miteinander verbunden, der eine abgeschrägte Außenkante des Rahmengestelles bildet,
b) die Übergänge zwischen dem Verbindungsabschnitt und den Profilseiten der Rahmenschenkel sind als senkrecht zu den Außenseiten des Rahmengestelles gerichtete, doppellagige Dichtungsstege oder als U-förmige Anlagestege mit einem parallel zur zugeordneten Außenseite verlaufenden Anlageabschnitt ausgebildet, wobei Dichtungsstege und Anlagestege auch die Länge Null haben können,
c) die Profilseiten gehen an den dem Verbindungsabschnitt abgekehrten Kanten in Aufnahmeabschnitte mit Befestigungsaufnahmen über, die senkrecht zur zugeordneten Profilseite stehen und zum Verbindungsabschnitt hin eingebogen sind, und
d) die Aufnahmeabschnitte gehen den Profilseiten abgekehrt in Endabschnitte über, die eine zur Querschnittsdiagonale symmetrische offene oder geschlossene Schwalbenschwanznut bilden.

Die so ausgebildeten und ausgerichteten Rahmenschenkel des Rahmengestelles sind nach wie vor leicht und mit ausreichender Stabilität, vorwiegend Verwindungssteifigkeit herstellbar, wobei sich die Herstellung als Stanz-Biege-Teil oder Strangpreßprofilabschnitt anbietet.

Die Dichtungsstege können mit Dichtungselementen an den Verkleidungselementen derart zusammenwirken, daß ein dichter Abschluß der offenen Seiten des Rahmengestelles erreicht wird. Sind Anlagestege ausgeformt, dann können diese auch die Dichtungselemente tragen. Der Verbindungsabschnitt läßt eine Außenkanten-Aufnahme am Rahmengestell entstehen, die vorzugsweise symmetrisch zur Querschnittsdiagonalen der Rahmenschenkelquerschnitte ist und ausreichend Platz für die Abkantungen der aufeinanderstoßenden Verkleidungselemente bietet, wobei genügend Platz vorhanden ist, auch die Scharnier- und Schließelemente einer Schranktür unterzubringen. Die als Schwalbenschwanznut auslaufende Aufnahme auf der Innenseite der Rahmenschenkel bringt ausgezeichnete Befestigungsmöglichkeiten für Montageschienen und dgl., wobei im einfachsten Fall eine Art Verrastung gewählt werden kann. Neben den Aufnahmeabschnitten sind auch die Profilseiten der Rahmenschenkel als Befestigungsflächen ausnützbar, was Befestigungsmöglichkeiten in mehreren Richtungen schafft.

Für die Abdichtung ist nach einer Ausgestaltung vorgesehen, daß die doppellagigen Dichtungsstege durch einen zu dem Verbindungsabschnitt im Winkel von 135 ° stehenden Stegabschnitt und einen Teil der Profilseiten gebildet sind, die über einen abgerundeten Übergang miteinander verbunden sind oder daß die Anlagestege durch einen zu dem Verbindungsabschnitt im Winkel von 135° stehenden Stegabschnitt und einen Teil der Profilseiten gebildet sind, die über den parallel zu den Außenseiten des Rahmengestelles verlaufenden Anlageabschnitt miteinander verbunden sind.

Die Aufnahme für die Montageschienen der Rahmenschenkel ist dadurch mit der Schwalbenschwanznut ergänzt, daß die offene Schwalbenschwanznut durch einfache Endabschnitte gebildet ist, die sich im stumpfen Winkel an die Aufnahmeabschnitte anschließen und in Richtung zu der zugeordneten Profilseite eingebogen sind oder daß die geschlossene Schwalbenschwanznut durch doppelt abgewinkelte Endabschnitte gebildet sind, wobei sich die ersten Teilabschnitte im stumpfen Winkel an die Aufnahmeabschnitte anschließen und in Richtung zu der zugeordneten Profilseite eingebogen sind, während die zweiten Teilabschnitte gegeneinander und parallel zu dem Verbindungsabschnitt ausgerichtet sind.

Dabei kann bei der geschlossenen Schwalbenschwanznut zusätzlich vorgesehen sein, daß die zweiten Teilabschnitte der doppelt abgewinkelten Endabschnitte an der Innenseite des Verbindungsabschnittes anliegen und vorzugsweise mit diesem verbunden, z.B. verklebt, verschweißt oder gepunktet sind, um die Verwindungssteifigkeit der Rahmenschenkel und damit des Rahmengestelles zu erhöhen.

Die Stabilität der Rahmenschenkel, insbesondere ihre Verwindungssteifikeit, läßt sich nach einer Weiterbildung dadurch noch verbessern, daß der Verbindungsabschnitt durch zwei nach außen gebogene Versteifungssicken versteift ist, die vorzugsweise symmetrisch zur Querschnittsdiagonalen angeordnet sind und jeweils einen zur zugekehrten Außenseite des Rahmengestelles vorzugsweise parallelen ersten Abschnitt und einen zur zugekehrten Profilseite vorzugsweise parallelen zweiten Abschnitt aufweisen.

Die universellen Befestigungsmöglichkeiten im Bereich der Innenseite des Rahmengestelles lassen sich dadurch erreichen, daß die Profilseiten und/oder die Aufnahmeabschnitte mit Reihen von Befestigungsaufnahmen (gegebenenfalls in einem Systemraster) versehen sind.

Die Erfindung wird anhand von in den Zeichnungen im Querschnitt dargestellten Rahmenschenkeln für ein Rahmengestell eines Schaltschrankes näher erläutert. Es zeigen:
- Fig. 1: einen Rahmenschenkel mit zwei Dichtungsstegen und einer Aufnahme mit offener Schwalbenschwanznut,
- Fig. 2: einen Rahmenschenkel mit zwei Anlagestegen und einer Aufnahme mit offener Schwalbenschwanznut,
- Fig. 3: einen Rahmenschenkel mit zwei Dichtungsstegen und einer Aufnahme mit geschlossener Schwalbenschwanznut,
- Fig. 4: einen Rahmenschenkel mit zwei Anlagestegen und einer Aufnahme mit geschlossener Schwalbenschwanznut,
- Fig. 5: einen Rahmenschenkel nach Fig. 3 mit zusätzlich versteiftem Verbindungsabschnitt und
- Fig. 6: einen Rahmenschenkel nach Fig. 4 mit zusätzlich versteiftem Verbindungsabschnitt.

Allen Ausführungsbeispielen ist gemeinsam, daß die Rahmenschenkel 10 vorzugsweise spiegelbildlich zur Querschnittsdiagonale 11 ausgebildet sind, so daß sie für jeden Rahmenschenkel des Rahmengestelles verwendbar sind. Die Ausrichtung im Rahmengestell ist stets so, daß die Rahmenschenkel 10 keine Außenkante bilden, zu dieser hin jedoch mit einem Verbindungsabschnitt 12 eine Außenkanten-Aufnahme bilden, in die die Abkantungen der Verkleidungselemente und Schranktüren ragen. Außerdem können am Verbindungsabschnitt 12 Scharnier- und Schließelemente befestigt werden.

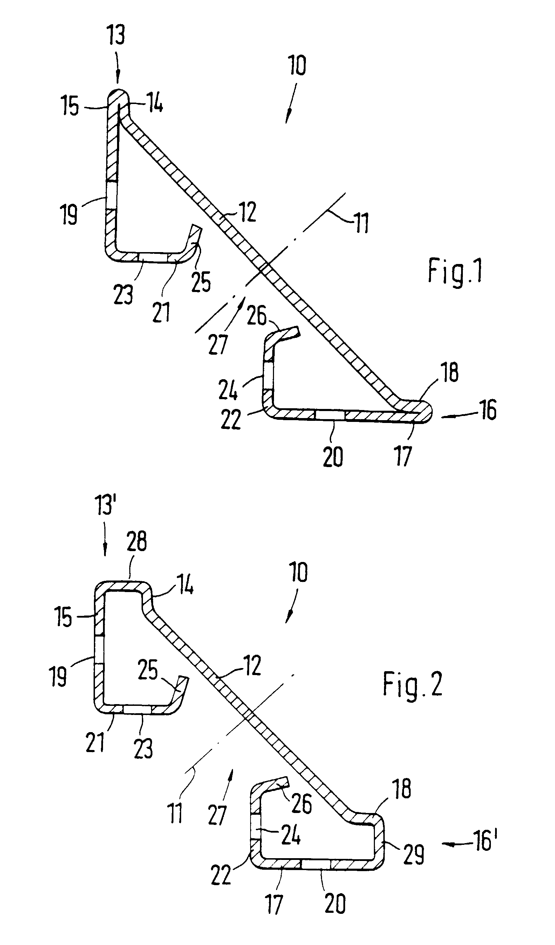

Beim Ausführungsbeispiel nach Fig. 1 geht der Verbindungsabschnitt 12 über Dichtungsstege 13 und 16 in Profilseiten 15 und 17 über, die mit Reihen von Befestigungsaufnahmen 19 uns 20 versehen sein können. Die Profilseiten 15 und 17 sind senkrecht zu den zugekehrten Außenseiten des Rahmengestelles ausgerichtet. Die Dichtungsstege 13 und 16 werden durch einen Stegabschnitt 14 und 18, der auch die Länge Null haben kann, sowie einen Teil der Profilseiten 15 und 17 doppellagig ausgebildet, wobei auch die Stegabschnitte 14 und 18 senkrecht zu den zugekehrten Außenseiten des Rahmengestelles stehen. Die Stegabschnitte 14 und 18 gehen abgerundet in die Profilseiten 15 und 17 über. Sind die Verkleidungselemente mit Dichtungselementen versehen, dann wird mit diesen am Rahmenschenkel 10 abstehenden Dichtungsstegen 13 und 16 eine eindeutige Abdichtung zwischen dem Rahmenschenkel 10 und den Verkleidungselementen erreicht.

Die Profilseiten 15 und 17 bilden Befestigungsflächen in zwei Richtungen. Die den Dichtungsstegen 13 und 16 abgekehrten Kanten der Profilseiten 15 und 17 gehen in Aufnahmeabschnitte 21 und 22 über, die ebenfalls mit Befestigungsaufnahmen 23 und 24 versehen sind und eine Aufnahme begrenzen, in der Montageschienen befestigt werden können. Diese Aufnahmeabschnitte 21 und 22 stehen senkrecht zu den Profilseiten 15 und 17 und sind in Richtung zum Verbindungsabschnitt 12 eingebogen. An die Aufnahmeabschnitte 21 und 22 schließen sich einfach abgekantete Endabschnitte 25 und 26 an, die im stumpfen Winkel zu den Aufnahmeabschnitten 21 und 22 stehen und eine offene Schwalbenschwanznut 27 begrenzen, in der auf einfache Weise auch die Montageschienen festgelegt werden können.

Wie das Ausführungsbeispiel nach Fig. 2 zeigt, können an den Übergängen von dem Verbindungsabschnitt 12 zu den Profilseiten 15 und 17 auch Anlagestege 13' und 16' ausgeformt sein, die aus den Stegabschnitten 14 und 18, die ebenfalls die Länge Null haben können, Anlageabschnitten 28 und 29 sowie Teilen der Profilseiten 15 und 17 gebildet sind. Die Anlageabschnitte 28 und 29 verlaufen parallel zu den zugekehrten Außenseiten des Rahmengestelles und können mit Dichtungselementen versehen sein. Der übrige Aufbau des Rahmenschenkels 10 unterscheidet sich nicht von dem Rahmenschenkel 10 nach Fig. 1.

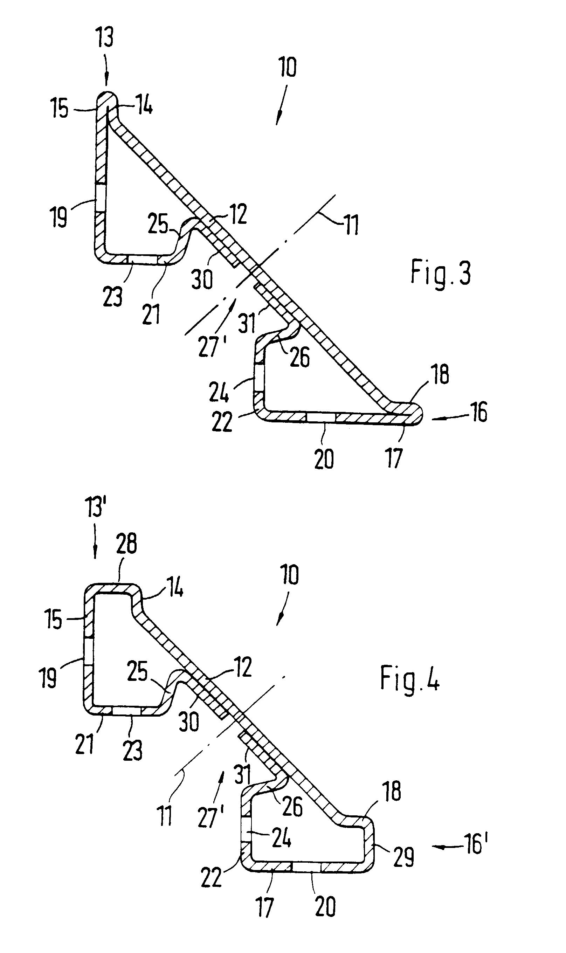

Wie die Ausführungsbeispiele nach Fig. 3 und 4 zeigen, können sich an die Aufnahmeabschnitte 21 und 22 auch doppelt abgewinkelte Endabschnitte 25, 30 und 26,31 anschließen, die eine geschlossene Schwalbenschwanznut 27' begrenzen. Die ersten Teilabschnitte stehen wieder im stumpfen Winkel zu den Aufnahmeabschnitten 21 und 22, während die zweiten Teilabschnitte parallel zum Verbindungsabschnitt 12 stehen und vorzugsweise an der Innenseite desselben anliegen und mit diesem verbunden, z.B. verklebt, verschweißt oder gepunktet sind.

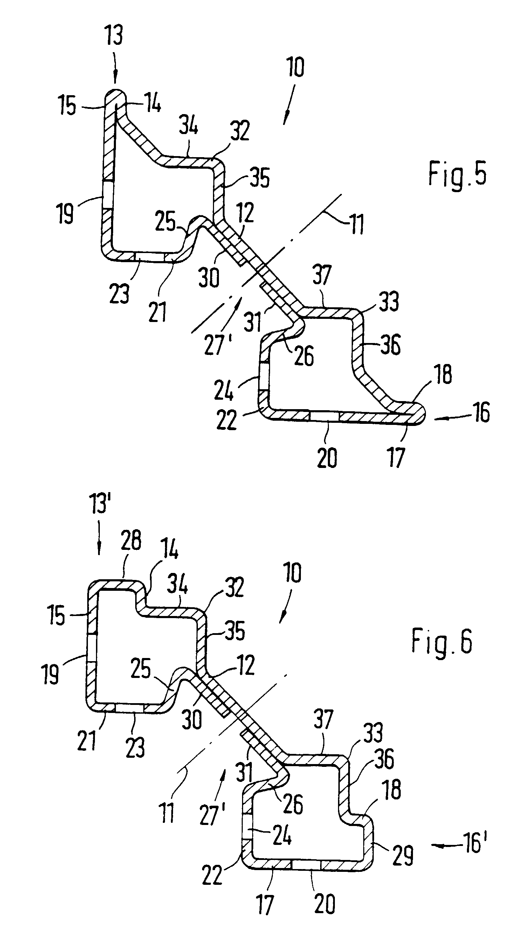

Wie die Ausführungsbeispiele nach Fig. 5 und 6 zeigen, kann die Verwindungssteifikgeit des Rahmenschenkels 10 durch zusätzliche Versteifung des Verbindungsabschnittes 12 erhöht werden. Vorzugsweise symmetrisch zur Querschnittsdiagonale 11 wird der Verbindungsabschnitt 12 durch zwei nach außen gebogene Versteifungssicken 32 und 33 versteift. Diese Versteifungssicken 32 und 33 umfassen jeweils einen Abschnitt 34 und 36, der zur zugekehrten Außenseite des Rahmengestelles vorzugsweise parallel verläuft, und einen Abschnitt 35 und 37, der zur zugekehrten Profilseite 15 und 17 vorzugsweise parallel gerichtet ist. Die Ausbuchtung ist dabei so, daß die Funktion der Dichtungsstege 13 und 16 bzw. der Anlagestege 13' und 16' nicht beeinträchtigt wird.

## Patentansprüche

1. Rahmengestell aus Rahmenschenkeln (10) für einen Schaltschrank, bei dem die Rahmenschenkel (10) vorzugsweise spiegelbildlich zu ihrer Querschnittsdiagonalen (11) ausgebildet sind und senkrecht zu den Außenseiten des Rahmengestelles stehende und mit Befestigungsaufnahmen (19, 20) versehene Profilseiten (15, 17) aufweisen, die im Bereich der Innenseite in Abschnitte (21, 22) übergehen, die eine Aufnahme (23, 24) zur Befestigung von Montageschienen bilden,
gekennzeichnet durch
die Kombination nachstehender Merkmale:
a) die Profilseiten (15,17) der Rahmenschenkel (10) sind über einen Verbindungsabschnitt (12) miteinander verbunden, der eine abgeschrägte Außenkante des Rahmengestelles bildet,
b) die Übergänge zwischen dem Verbindungsabschnitt (12) und den Profilseiten (15,17) der Rahmenschenkel (10) sind als senkrecht zu den Außenseiten des Rahmengestelles gerichtete, doppellagige Dichtungsstege (13,16) oder als U-förmige Anlagestege (13',16') mit einem parallel zur zugeordneten Außenseite verlaufenden Anlageabschnitt (28,29) ausgebildet, wobei die Dichtungsstege (13,16) und Anlagestege (13', 16') auch die Länge Null haben können,
c) die Profilseiten (15,17) gehen an den dem Verbindungsabschnitt (12) abgekehrten Kanten in Aufnahmeabschnitte (21,22) mit Befestigungsaufnahmen (23,24) über, die senkrecht zur zugeordneten Profilseite (15,17) stehen und zum Verbindungsabschnitt (12) hin eingebogen sind, und
d) die Aufnahmeabschnitte (21,22) gehen den Profilseiten (15,17) abgekehrt in Endabschnitte (25,26 bzw. 25,30; 26,31) über, die eine zur Querschnittsdiagonale (11) vorzugsweise symmetrische offene oder geschlossene Schwalbenschwanznut (27,27') bilden.

2. Rahmengestell nach Anspruch 1,
dadurch gekennzeichnet,
daß die doppellagigen Dichtungsstege (13,16) durch einen zu dem Verbindungsabschnitt (12) im Winkel von 135° stehenden Stegabschnitt (14,18), der auch die Länge Null haben kann, und einen Teil der Profilseiten (15,17) gebildet sind, die über einen abgerundeten Übergang miteinander verbunden sind.

3. Rahmengestell nach Anspruch 1,
dadurch gekennzeichnet,
daß die Anlagestege (13',16') durch einen zu dem Verbindungsabschnitt (12) im Winkel von 135° stehenden Stegabschnitt (14,18), der auch die Länge Null haben kann, und einen Teil der Profilseiten (15,17) gebildet sind, die über den parallel zu den Außenseiten des Rahmengestelles verlaufenden Anlageabschnitt (28,29) miteinander verbunden sind.

4. Rahmengestell nach einem der Ansprüche 1 bis 3,
dadurch gekennzeichnet,
daß die offene Schwalbenschwanznut (27) durch einfache Endabschnitte (25,26) gebildet ist, die sich im stumpfen Winkel an die Aufnahmeabschnitte (21,22) anschließen und in Richtung zu der zugeordneten Profilseite (15,17) eingebogen sind.

5. Rahmengestell nach einem der Ansprüche 1 bis 3,
dadurch gekennzeichnet,
daß die geschlossene Schwalbenschwanznut (27) durch doppelt abgewinkelte Endabschnitte (25,30; 26,31) gebildet sind, wobei sich die ersten Teilabschnitte im stumpfen Winkel an die Aufnahmeabschnitte (21,22) anschließen und in Richtung zu der zugeordneten Profilseite (15,17) eingebogen sind, während die zweiten Teilabschnitte gegeneinander und parallel zu dem Verbindungsabschnitt (12) ausgerichtet sind.

6. Rahmengestell nach Anspruch 5,
dadurch gekennzeichnet,
daß die zweiten Teilabschnitte der doppelt abgewinkelten Endabschnitte (25,30; 26,31) an der Innenseite des Verbindungsabschnittes (12) anliegen und vorzugsweise mit diesem verbunden, z.B. verklebt, verschweißt oder gepunktet sind.

7. Rahmenschenkel nach einem der Ansprüche 1 bis 6,
dadurch gekennzeichnet,
daß der Verbindungsabschnitt (12) durch zwei nach außen gebogene Versteifungssicken (32,33) versteift ist, die vorzugsweise symmetrisch zur Querschnittsdiagonale (11) angeordnet sind und jeweils einen zur zugekehrten Außenseite des Rahmengestelles vorzugsweise parallelen ersten Abschnitt (34,36) und einen zur zugekehrten Profilseite (15,17) vorzugsweise parallelen zweiten Abschnitt (36,37) aufweisen.

8. Rahmenschenkel nach einem der Ansprüche 1 bis 7,
dadurch gekennzeichnet,
daß die Profilseiten (15,17) und/oder die Aufnahmeabschnitte (21,22) mit Reihen von Befestigungsaufnahmen (19,20,23,24) in einem Systemraster versehen sind.

## Claims

1. Framework, comprising frame members for a switchgear cabinet, wherein the frame members are preferably provided as mirror images of each other at their cross-sectional diagonal and include profile sides, which lie perpendicularly relative to the external surfaces of the framework and are provided with fastening holes (19, 20), said profile sides extending, in the region of the internal surface, into portions which form a receiver for the securement of mounting bars, characterised by the combination of the following features:
a) the profile sides (15, 17) of the frame members (10) are interconnected via a connecting portion (12), which forms a chamfered outer edge of the framework;
b) the transitional regions between the connecting portion (12) and the profile sides (15, 17) of the frame members (10) are configured as double-layered sealing webs (13, 16), which are orientated perpendicularly relative to the external surfaces of the framework, or as U-shaped abutment webs (13', 16') having an abutment portion (28, 29) extending parallel to the associated external surface, the sealing webs (13, 16) and abutment webs (13', 16') also being able to have the length zero;
c) the profile sides (15, 17) extend into receiving portions (21, 22) provided with fastening holes (23, 24) at the edges remote from the connecting portion (12), said receiving portions lying perpendicularly relative to the associated profile side (15, 17) and being bent inwardly towards the connecting portion (12); and
d) the receiving portions (21, 22), remote from the profile sides (15, 17), extend into end portions (25, 26, or respectively 25, 30; 26, 31), which form an open or closed dovetail groove (27, 27') preferably symmetrical with the cross-sectional diagonal (11).

2. Framework according to claim 1, characterised in that the double-layered sealing webs (13, 16) are formed by a web portion (14, 18), which lies at an angle of 135° relative to the connecting portion (12) and may also have the length zero, and by a part of the profile sides (15, 17), which are interconnected via a rounded transitional region.

3. Framework according to claim 1, characterised in that the abutment webs (13', 16') are formed by a web portion (14, 18), which lies at an angle of 135° relative to the connecting portion (12) and may also have the length zero, and by a part of the profile sides (15, 17), which are interconnected via the abutment portion (28, 29) extending parallel to the external surfaces of the framework.

4. Framework according to one of claims 1 to 3, characterised in that the open dovetail groove (27) is formed by simple end portions (25, 26), which communicate with the receiving portions (21, 22) at an obtuse angle and are bent inwardly towards the associated profile side (15, 17).

5. Framework according to one of claims 1 to 3, characterised in that the closed dovetail groove (27) is formed by doubly-angled end portions (25, 30; 26, 31), the first part-portions communicating with the receiving portions (21, 22) at an obtuse angle and being bent inwardly towards the associated profile side (15, 17), while the second part-portions are orientated opposite each other and parallel to the connecting portion (12).

6. Framework according to claim 5, characterised in that the second part-portions of the doubly-angled end portions (25, 30; 26, 31) abut against the internal surface of the connecting portion (12) and are preferably connected thereto, e.g. glued, welded or spot-welded.

7. Frame member according to one of claims 1 to 6, characterised in that the connecting portion (12) is reinforced by two outwardly bent reinforcing beads (32, 33), which are preferably disposed symmetrically relative to the cross-sectional diagonal (11) and each include a first portion (34, 36), which preferably extends parallel to the facing external surface of the framework, and a second portion (36, 37), which preferably extends parallel to the facing profile side (15, 17).

8. Frame member according to one of claims 1 to 7, characterised in that the profile sides (15, 17) and/or the receiving portions (21, 22) are provided with rows of fastening holes (19, 20, 23, 24) in a system raster pattern..

## Revendications

1. Cadre pour armoire de distribution constitué de montants d'ossature (10), où les montants (10) sont de préférence symétriques par rapport à la diagonale (11) de leur section transversale et où ces montants présentent des faces latérales (15, 17) de profilés perpendiculaires par rapport aux faces externes du cadre d'ossature et sont dotées de logements de fixation (19, 20), ces faces latérales de profilés se prolongeant du côté intérieur par des tronçons (21, 22) qui forment un logement (23, 24) pour la fixation de rails de montage, le cadre présentant en combinaison les caractéristiques ci-dessous:
a) les faces latérales (15, 17) des profilés des montants d'ossature (10) sont reliées l'une à l'autre par un tronçon de liaison (12), ce tronçon formant une arête extérieure chanfreinée du cadre,
b) les transitions entre le tronçon de liaison (12) et les faces latérales (15, 17) du profilé des montants d'ossature (10) sont conçues comme des membrures d'étanchéité (13, 16) d'épaisseur double perpendiculaires aux faces externes du cadre d'ossature, ou comme des membrures d'appui (13',16') en forme de U avec un tronçon d'appui (28, 29) parallèle à la face externe correspondante, les membrures d'étanchéité (13, 16), aussi bien que les membrures d'appui (13', 16') pouvant être de longueur nulle.
c) les faces latérales (15, 17) des profilés se prolongent, du côté des arêtes opposées au tronçon de liaison (12), en tronçons de réception (21,22) comportant des logements de fixation (23, 24), ces tronçons de réception étant perpendiculaires à la face latérale (15, 17) correspondante du profilé et repliés en direction du tronçon de liaison (12).
d) les tronçons de réception (21, 22) se prolongent, du côté opposé aux faces latérales (15, 17) du profilé, sous forme de tronçons terminaux (25, 26 ou 25, 30; 26, 31) qui constituent une rainure en forme de queue d'aronde ouverte ou fermée (27, 27'), rainure qui est de préférence symétrique par rapport à la diagonale (11) de leur section transversale.

2. Cadre suivant la revendication 1,
caractérisé
en ce que les membrures d'étanchéité d'épaisseur double (13, 16) sont formées d'une part, d'un tronçon de membrure (14, 18) formant, par rapport au tronçon de liaison (12), un angle de 135 degrés, ce tronçon de membrure pouvant aussi être de longueur nulle, et d'autre part d'une partie des faces latérales (15, 17) du profilé, la transition entre le tronçon de membrure et la face latérale se faisant via une partie arrondie.

3. Cadre suivant la revendication 1,
caractérisé
en ce que les membrures d'appui (13', 16') sont constituées d'une part d'un tronçon de membrure (14, 18) formant, par rapport au tronçon de liaison (12), un angle de 135 degrés, ce tronçon de membrure pouvant aussi être de longueur nulle, et d'autre part d'une partie des faces latérales (15, 17) du profilé, la transition se faisant via le tronçon d'appui (28, 29) qui est parallèle aux faces externes du cadre.

4. Cadre suivant l'une quelconque des revendications de 1 à 3,
caractérisé
en ce que la rainure en forme de queue d'aronde ouverte (27) est formée au moyen de simples tronçons terminaux (25, 26) qui se raccordent suivant un angle obtus aux tronçons de réception (21, 22) et qui sont cintrés en direction des faces latérales (15, 17) correspondantes de profilé.

5. Cadre suivant l'une quelconque des revendications de 1 à 3,
caractérisé
en ce que les rainures en forme de queue d'aronde fermées (27') sont constituées de tronçons terminaux (25, 30; 26, 31) à double coude, où les premiers tronçons de réception (21, 22) se raccordent sous un angle obtus aux tronçons de réception (21, 22) et sont cintrés en direction des faces (15, 178) correspondantes de profilé, tandis que les deuxièmes tronçons partiels sont orientés l'un vers l'autre, parallèlement au tronçon de liaison (12).

6. Cadre suivant la revendication 5,
caractérisé
en ce que les deuxièmes tronçons partiels des tronçons terminaux à double coude (25, 30; 26, 31) viennent s'appliquer sur la face interne du tronçon de liaison (12) et sont de préférence reliés celui-ci, par collage, soudure ou soudure par points, par exemple.

7. Cadre suivant l'une quelconque des revendications de 1 à 6,
caractérisé
en ce que le tronçon de liaison (12) est raidi au moyen de deux nervures de raidissement (32, 33) faisant un pli vers l'extérieur, ces nervures étant disposées de préférence de manière symétrique par rapport à la diagonale (11) de la section transversale et comportent de chaque côté un premier tronçon (34, 36) de préférence parallèle à la face externe correspondante du cadre et un deuxième tronçon (36, 37), de préférence parallèle à la face latérale (15, 17) correspondante du profilé.

8. Cadre suivant l'une quelconque des revendications de 1 à 7 ,
caractérisé
en ce que les faces (15,17) du profilé et/ou les tronçons de réception (21, 22) sont pourvus de séries de logements de fixation (19, 20, 23, 24) disposés suivant une grille d'un pas uniforme.
